# EUROPÄISCHE PATENTSCHRIFT

(11) **EP 3 360 341 B1**
(45) Veröffentlichungstag und Bekanntmachung des Hinweises auf die Patenterteilung: **27.05.2020**
(21) Anmeldenummer: 16784410.9
(22) Anmeldetag: 30.09.2016
(51) Int. Cl.: H04R 25/00, H04R 1/10, H03K 17/94, H03K 17/955

(54) **HÖRGERÄT MIT EINEM OHRSTÜCK**
HEARING DEVICE COMPRISING AN EARPIECE
APPAREIL AUDITIF AVEC UNE PARTIE AURICULAIRE

(30) Priorität: 06.10.2015 DE 102015219310
(43) Veröffentlichungstag der Anmeldung: 15.08.2018
(73) Patentinhaber: Sivantos Pte. Ltd., Singapore 539775 (SG)
(72) Erfinder: HUSUNG, Kunibert, 91052 Erlangen (DE); NAUMANN, Frank, 91088 Bubenreuth (DE)
(74) Vertreter: FDST Patentanwälte
(86) Internationale Anmeldenummer: PCT/EP2016/073499
(87) Internationale Veröffentlichungsnummer: WO 2017/060176

(56) Entgegenhaltungen:
- DE-A1- 3 840 393
- US-A- 4 332 468
- US-A- 4 955 729
- US-A1- 2005 238 190
- US-A1- 2014 213 323
- US-B1- 6 532 294

## Beschreibung

Die Erfindung betrifft ein Hörgerät, insbesondere Hörhilfegerät, mit einem Ohrstück und einer Steuereinheit, wobei das Ohrstück für den Betrieb des Hörgeräts wenigstens teilweise in den äußeren Gehörgang eines Benutzers des Hörgeräts einführbar ist, und wobei die Steuereinheit dazu eingerichtet ist, einen Betriebszustand des Hörgerätes zu steuern.

In einem Hörgerät stellt aufgrund der geringen Abmessungen die Leistungsversorgung grundsätzlich eine der wesentlichen Herausforderungen dar. Ein Hörgerät umfasst meist wenigstens einen akusto-elektrischen Wandler, der z.B. durch ein Mikrofon gegeben sein kann, eine Signalverarbeitungseinheit, und wenigstens einen elektro-akustischen Wandler, der beispielsweise durch einen Lautsprecher gegeben sein kann.

Im Betrieb des Hörgeräts wird nun durch den akusto-elektrischen Wandler Schall aus der Umgebung in ein elektrisches Eingangssignal gewandelt, welches von der Signalverarbeitungseinheit u.a. verstärkt und ggf. durch Filterprozesse o.ä. zu einem Ausgangssignal weiter verarbeitet wird, aus welchem der elektro-akustischen Wandler ein Schallsignal erzeugt, welches einem Gehör eines Benutzers des Hörgeräts zugeführt wird. Die Signalverarbeitung umfasst hierbei meist einen Analog-Digital-Wandler zur Digitalisierung des Eingangssignals und einen Digital-Analog-Wandler für das Ausgangssignal. Je nach Bauweise des Hörgeräts können auch noch weitere Komponenten wie z.B. ein elektro-magnetischer Signalempfänger zum Empfang von Audio-Signalen (sog. "Telecoil") oder bei binauralen Hörgerätesystemen auch eine Übertragungseinheit für die Kommunikation mit dem jeweils anderen Hörgerät vorgesehen sein.

Die genannten Komponenten tragen hierbei im Betrieb des Hörgeräts jeweils zum Verbrauch der Leistung bei, welche im Hörgerät durch eine Leistungsquelle, die üblicherweise eine Batterie oder einen Akkumulator umfasst, bereit gestellt wird. Selbst wenn durch einen Benutzer des Hörgeräts eine geringe Verstärkung in der Signalverarbeitung angewählt wird, kann in einem dauerhaft aufrecht erhaltenen Betriebszustand ein verglichen mit der insgesamt zur Verfügung stehenden Leistung erheblicher Verbrauch resultieren. Vor dem Hintergrund der Anforderungen an die Dimensionierung der Leistungsquelle und die sich daraus ergebenden Einschränkungen an die zur Verfügung stehenden Energie im Hörgerät der Verbrauch daher möglichst auf ein Mindestmaß zu reduzieren.

Hierfür ist meist ein Standby-Betriebszustand vorgesehen, in welchem die im Hörgerät aktiven Funktionen auf ein Minimum reduziert werden. So kann beispielsweise die Erzeugung des Eingangssignals sowie die Signalverarbeitung und damit auch die Wandlung des Ausgangssignals in Schall deaktiviert werden, und nur ein Minimalbetrieb, welcher zum erneuten Aktivieren der genannten Funktionen für den normalen Betriebszustand erforderlich ist, aufrecht erhalten werden. Für den Übergang zwischen dem Standby- und dem normalen Betriebszustand stellt sich hierbei jedoch das Problem, dass einerseits infolge der Abmessungen des Hörgeräts ein eigenes Schaltmittel am Hörgerät eigentlich unerwünscht ist, da der knapp bemessene, verfügbare Platz meist für Schaltmittel zur Bedienung der normalen Hörgerätefunktionen genutzt werden soll, wie z.B. Steuerung der Lautstärke oder Anwahl des Betriebsprogramms, andererseits jedoch dieser Übergang möglichst in Abhängigkeit der Wünsche des Benutzers steuerbar gestaltet sein sollte.

In der DE 10 2008 054 087 A1 ist ein Hörgerät mit einem kapazitiven Näherungssensor gezeigt, wobei mittels des Näherungssensors erkannt wird, ob das Hörgerät im Ohr getragen wird, und entsprechend an- oder abgeschaltet wird. Der Näherungssensor kann auch so angeordnet und ausgestaltet sein, dass er zum Erfassen von Handbewegungen des Benutzers eingerichtet ist, über welche Bedienfunktionen des Hörgerätes angesteuert werden können. Hierzu können auch zwei Näherungssensoren verwendet werden.

In der US 2011/0091058 A1 wird ein Hörgerät mit zwei kapazitiven Sensoren beschrieben, wobei ein erster Sensor an der äußeren Batterieklappe auf Fingerbewegungen reagiert, und ein zweiter Sensor im Inneren des Ohres angeordnet ist. Der zweite Sensor ist hierbei zum Erfassen eines Körperkontaktes und damit eines Tragezustands vorgesehen, um anhand der Erfassung das Hörgerät an- oder auszuschalten. Die Menge an Funktionen, welche durch den ersten Sensor mittels Fingerbewegungen bedienbar sind, können dabei vom anhand des zweiten Sensors detektierten Tragezustand abhängen.

Die DE 38 40 393 A1 nennt ein Hörgerät mit einer Fühleinrichtung zum Ein- und Ausschalten der Energieversorgung. Die Fühleinrichtung ist dabei in einer Seitenwand eines Gehäuses des Hörgerätes angeordnet, und kann somit durch mechanisch durch eine Berührung der Haut der Concha oder mittels einer in der Fühleinrichtung entsprechend ausgestalteten Elektrode über einen Hautwiderstand der Concha angesteuert werden.

Die US 2005 / 0 238 190 A1 nennt ein ITE-Hörgerät mit zwei Abstandssensoren, welche in der Deckplatte des Hörgerätes angeordnet und somit bei einem Tragen des Hörgerätes dem freien Raum außerhalb des Ohres zugewandt sind. Ein Träger des Hörgerätes kann durch eine Handbewegung am Ohr vorbei, welche von den Abstandssensoren erkannt wird, Funktionen des Hörgerätes ansteuern.

Die US 2014 / 0213 323 A1 offenbart einen Abstandssensor mit einem Paar von flächigen, komplanar oder vertikal gegeneinander versetzt angeordneten Elektroden zum Ansteuern eines elektronischen Gerätes, insbesondere eines Mobiltelefons.

Der Erfindung liegt daher die Aufgabe zugrunde, ein Hörgerät anzugeben, welches dazu eingerichtet ist, möglichst einfach einen vom Benutzer des Hörgeräts gewünschten Betriebszustand einzunehmen, und dabei einen möglichst geringen Leistungsverbrauch ermöglichen soll.

Die genannte Aufgabe wird erfindungsgemäß gelöst durch ein Hörgerät, insbesondere Hörhilfegerät, umfassend ein Ohrstück mit einem ersten Abstandssensor und einem zweiten Abstandssensor sowie eine Steuereinheit, wobei der erste Abstandssensor dazu eingerichtet ist, ein erstes Abstandssignal an die Steuereinheit zu übermitteln, wobei der zweite Abstandssensor dazu eingerichtet ist, ein zweites Abstandssignal an die Steuereinheit zu übermitteln, wobei das Ohrstück für den Betrieb des Hörgeräts wenigstens teilweise in den äußeren Gehörgang eines Benutzers des Hörgeräts einführbar ist und wobei die Steuereinheit dazu eingerichtet ist, in Abhängigkeit von Veränderungen des ersten Abstandssignals und des zweiten Abstandssignals einen Betriebszustand des Hörgerätes zu steuern. Konkret ist die Steuereinheit dazu eingerichtet, im Falle einer bei einem Einführen des Hörgeräts in den äußeren Gehörgang eintretenden Veränderung des ersten Abstandssignals und einer in einem vorgegebenen Zeitabstand darauf folgenden Veränderung des zweiten Abstandssignals das Hörgerät in einen aktiven Betriebszustand zu versetzen, und/oder im Falle einer bei einem Entfernen des Hörgeräts aus dem äußeren Gehörgang eintretenden Veränderung des zweiten Abstandssignals und einer in einem vorgegebenen Zeitabstand darauf folgenden Veränderung des ersten Abstandssignals das Hörgerät in einen inaktiven Betriebszustand zu versetzen. Der erste Abstandssensor und der zweite Abstandssensor sind dabei im Ohrstück bezüglich einer Einführrichtung des Hörgeräts in den äußeren Gehörgang hintereinander angeordnet. Vorteilhafte und teils für sich gesehen erfinderische Ausgestaltungen sind Gegenstand der Unteransprüche und der nachfolgenden Beschreibung.

Bevorzugt ist das Ohrstück im Falle eines BTE-Hörgerätes ("Behind The Ear") gegeben durch ein Ohrpassstück, welches über einen Schallschlauch mit dem Gehäuse des Hörgeräts verbunden ist. Im Fall eines RIC-Hörgeräts ("Receiver In the Canal") umfasst das Ohrstück bevorzugt den Lautsprecher des Hörgeräts. In den beiden genannten Fällen sind der erste Abstandssensor und der zweite Abstandssensor bevorzugt mittels entsprechender Signalverbindungen mit der Steuereinheit verbunden, welche über den Schallschlauch (BTE) bzw. über einen ebenfalls die die Hörerverbindung umfassenden Signalkanal (RIC) geführt sind. Im Fall eines ITE-Hörgerätes ("In The Ear") kann das Ohrstück als ein Teil des Gehäuses des Hörgeräts ausgebildet sein. Insbesondere ist das Ohrstück im bestimmungsgemäßen Betrieb des Hörgeräts in den äußeren Gehörgang des Benutzers des Hörgeräts eingeführt.

Der erste Abstandssensor und der zweite Abstandssensor sind jeweils insbesondere als berührungsloser Abstandssensor oder als taktiler Sensor ausgestaltet. Unter einer Veränderung des ersten Abstandssignals bzw. des zweiten Abstandssignals ist hierbei insbesondere umfasst, dass sich der in der Steuereinheit registrierte Signalpegel verändert. Ist eines der Abstandssignale beispielsweise durch ein Spannungssignal, so ist eine Veränderung dieses Abstandssignals insbesondere durch eine Änderung der Signalspannung gegeben. Ebenso ist jedoch auch ein gepulster Betrieb der Abstandssensoren umfasst, wobei der jeweilige Abstandssensor zu vorgesehenen Abfragezeiten jeweils einen Signalpuls seines Abstandssignals eigenständig an die Steuereinheit übermittelt, oder die Steuereinheit zu vorgesehenen Abfragezeiten jeweils das Senden des Signalpulses vom jeweiligen Abstandssensor anfragt. Insbesondere ist eine solche Anfrage seinerseits durch das Aussenden eines Abfragepulses zum gegebenen Abfragezeitpunkt an den jeweiligen Abstandssensor realisiert, z.B. durch das kurzfristige und somit pulsartige Anlegen einer Signalspannung an den Abstandssensor durch die Steuereinheit. Der erste Abstandssensor und der zweite Abstandssensor sind dabei bevorzugt dazu eingerichtet, durch einen menschlichen Körper beeinflusst zu werden, d.h., anhand des jeweiligen Abstandssignals kann wenigstens näherungsweise bestimmt werden, ob sich ein Teil eines menschlichen Körpers zu einem gegebenen Zeitpunkt in Reichweite des jeweiligen Abstandssensors befindet.

Die Anordnung des ersten Abstandssensors und des zweiten Abstandssensors hintereinander bezüglich einer Einführrichtung ist dabei insbesondere so zu verstehen, dass durch die Bewegungsrichtung des Ohrstücks beim Einführen in den äußeren Gehörgang am Ohrstück eine Vorzugsrichtung definiert wird, die eine Referenz für die Anordnung der Abstandssensoren liefert. Die Anordnung hintereinander bedeutet in diesem Zusammenhang, dass einer der beiden Abstandssensoren bei einem Einführen eine im Rahmen der zeitlichen Auflösungsmöglichkeiten merklich frühere Veränderung in seinem Abstandssignal erfährt als der andere Abstandssensor. insbesondere liegen hierfür die beiden Abstandssensoren in Einführrichtung direkt aneinander, oder im Ohrstück auch gegenüber, jedoch bezüglich der Einführrichtung mit einer gewissen Versetzung. Letztere Ausgestaltung ist besonders vorteilhaft, da durch die räumliche Trennung der beiden Abstandssensoren eine unerwünschte Veränderung in den Abstandssignalen bereits beim Anfassen des Ohrstücks besser unterbunden werden kann.

Als vorgegebener Zeitabstand für die Veränderungen der beiden Abstandssignale ist hierbei insbesondere ein Zeitabstand aus einem vorgegebenen Intervall umfasst. Der vorgegebene Zeitabstand bzw. das Intervall ist hierbei so zu wählen, dass eine Einführbewegung des Ohrstücks in den äußeren Gehörgang des Benutzers und/oder ein Entfernen des Ohrstücks aus dem äußeren Gehörgang bei üblichermaßen anzunehmenden Bewegungsabläufen erkannt werden kann. Die entsprechenden Bewegungsgeschwindigkeiten sind dabei bevorzugt abzuschätzen oder exemplarisch zu messen. Bevorzugt ist im aktiven Betriebszustand das Hörgerät zum Betrieb mit allen wesentlichen Funktionen eingerichtet, wobei im inaktiven Betriebszustand alle wesentlichen Funktionen des Hörgeräts, ggf. mit Ausnahme der Energieverwaltung und der Steuerung der Betriebszustände selbst, deaktiviert sind.

Eine Veränderung im ersten Abstandssignal des ersten Abstandssensors bzw. im zweiten Abstandssignal des zweiten Abstandssensors tritt insbesondere dann ein, wenn das Ohrstück zum bestimmungsgemäßen Betrieb in den äußeren Gehörgang des Benutzers des Hörgeräts eingeführt wird. Es kann nämlich angenommen werden, dass das Hörgerät vor dem Betrieb in einer Weise aufbewahrt wird, in welcher die beiden Abstandssensoren keine nennenswerte Nähe zu einem menschlichen Körperteil registrieren, beispielsweise auf einer freien Unterlage oder in einem für die Abstandssensoren abgeschirmten Etui. Bei einem Einführen in den Äußeren Gehörgang wird nun durch den ersten Abstandssensor und den zweiten Abstandssensor eine derartige unmittelbare Nähe zu einem Teil des menschlichen Körpers, in diesem Falle zur Haut im äußeren Gehörgang, registriert. Diese Änderung führt im ersten Abstandssignal und im zweiten Abstandssignal zu Veränderungen, anhand derer die Steuereinheit auf ein entsprechendes Einführen in den äußeren Gehörgang schließen kann. Dies erlaubt der Steuereinheit, darauf zu schließen, dass nun der Benutzer den bestimmungsgemäßen Betrieb des Hörgeräts erwünscht, da er das Hörgerät entsprechend positioniert hat. Gleichsam erfolgt üblicherweise bei einem Entfernen des Ohrstücks aus dem äußeren Gehörgang zum Beenden des bestimmungsgemäßen Betriebs eine Veränderung in den beiden Abstandssignalen, da die beiden Abstandssensoren nun nicht mehr die Nähe zur Haut im äußeren Gehörgang registrieren. Somit kann die Steuereinheit darauf schließen, dass nun der bestimmungsgemäße Betrieb nicht mehr erforderlich ist, und zum Schonen der Leistungsquelle einen inaktiven Betriebszustand des Hörgeräts ansteuern.

Hierbei hat ein Ermitteln der Positionierung anhand zweier Abstandssensoren den Vorteil, dass die Abstandssensoren dazu derart im Ohrstück angeordnet werden können - z.B. hintereinander in Einführrichtung oder gegenüber liegend - dass Vorgänge, bei welchen nur ein Abstandssensor eine Veränderung in seinem Abstandssignal erzeugt, beispielsweise ein Anfassen zum Transport oder versehentliche Berührungen, als Vorgänge erkannt werden, bei welchen kein anderer betriebszustand anzusteuern ist.

Die Erfindung erlaubt somit, auf besonders einfache Weise zu erkennen, welcher Betriebszustand vom Benutzer des Hörgeräts gewünscht ist, und entsprechend für einen geringen Leistungsverbrauch einen inaktiven Betriebszustand anzusteuern, ohne dass hierfür gesonderte aufwendige Bedienelemente erforderlich wären.

Günstigerweise ist die Steuereinheit dazu eingerichtet, den Betriebszustand des Hörgerätes in Abhängigkeit einer zeitlichen Abfolge von Veränderungen des ersten Abstandssignals und des zweiten Abstandssignals zu steuern. Wird das Ohrstück für den bestimmungsgemäßen Betrieb des Hörgeräts in den äußeren Gehörgang eingeführt oder zur Beendigung des Betriebs aus dem äußeren Gehörgang entfernt, so treten die entsprechenden Veränderungen im ersten Abstandssignal und im zweiten Abstandssignal aufgrund der Relativbewegung des Ohrstücks zum äußeren Gehörgang bei einer geeigneten Positionierung des ersten Abstandssensors und des zweiten Abstandssensors mit zeitlicher Verzögerung zueinander ein. Anhand der Abfolge der Veränderungen des ersten bzw. zweiten Abstandssignals kann nun von der Steuereinheit eine Bewegung sowie eine Bewegungsrichtung des Ohrstücks relativ zum äußeren Gehörgang erkannt werden. Hieraus kann geschlossen werden, ob der Benutzer den bestimmungsgemäßen Betrieb gerade aufnehmen oder beenden möchte, und entsprechend der Betriebszustand des Hörgeräts gesteuert werden.

In einer vorteilhaften Ausgestaltung der Erfindung wird das erste Abstandssignal vom ersten Abstandssensor in einem gepulsten Betrieb mit einer definierten ersten Pulswiederholfrequenz an die Steuereinheit übermittelt und/oder das zweite Abstandssignal vom zweiten Abstandssensor in einem gepulsten Betrieb mit einer definierten zweiten Pulswiederholfrequenz an die Steuereinheit übermittelt. Insbesondere bedeutet dies, dass das erste Abstandssignal bzw. das zweite Abstandssignal nicht kontinuierlich an die Steuereinheit übermittelt werden, sondern durch jeweilige Signalpulse in anhand der entsprechenden Pulswiederholfrequenz vorgegebenen Zeitabständen erneute Statusabfragen erfolgen. Insbesondere ist dabei die erste Pulswiederholfrequenz identisch zur zweiten Pulswiederholfrequenz. Durch einen gepulsten Betrieb ist es nicht erforderlich, die Abstandssensoren kontinuierlich mit Leistung zu versorgen, wodurch der Verbrauch weiter reduziert werden kann.

Zweckmäßigerweise wird hierbei die definierte erste Pulswiederholfrequenz und/oder die definierte zweite Pulswiederholfrequenz nach einem vorgegebenen Zeitintervall in einem aktiven und/oder inaktiven Betriebszustand des Hörgeräts verringert wird. Insbesondere ist hierbei umfasst, dass die Wiederholung der einzelnen Signalpulse des ersten Abstandssignals bzw. des zweiten Abstandssignals nach und nach ihre Zeitabstände zueinander vergrößern, je länger derselbe Betriebszustand vorliegt. Hierbei wird von der Überlegung ausgegangen, dass nach einem Einführen des Ohrstücks in den äußeren Gehörgang zum Beginn des Betriebs des Hörgeräts der Betrieb meist für eine in der Zeitskala der Pulswiederholfrequenz sehr lange Dauer aufrecht erhalten wird. Während hierbei am Anfang ggf. noch Anpassungsbewegungen mit dem Ohrstück durchgeführt werden können, welche zu erneuten Veränderungen in den Abstandssignalen führen können, sinkt mit zunehmender Dauer des Betriebs die Wahrscheinlichkeit eines erneuten Entfernens, der Betrieb wird nun in der genannten Zeitskala lange aufrecht erhalten. Umgekehrt wird das Hörgerät - die genannten Anpassungsbewegungen bei der Aufnahme des Betriebs ausgenommen - nach einmaligem Entfernen des Ohrstücks zur Beendigung des Betriebs meist nicht mehr direkt wieder in Betrieb genommen, sondern verbleibt meist für eine in der genannten Zeitskala lange Dauer außer Betrieb. Durch die Verringerung der jeweiligen Pulswiederholfrequenz für den gepulsten Betrieb des jeweiligen Abstandssensors wird diesem Umstand in vorteilhafter Weise Rechnung getragen, da hierdurch der Leistungsverbrauch, welcher durch den Betrieb der Abstandssensoren selbst verursacht wird, weiter reduziert werden kann.

In einer weiter vorteilhaften Ausgestaltung der Erfindung ist der erste Abstandssensor und/oder der zweite Abstandssensor jeweils als ein berührungsloser Abstandssensor ausgebildet. Insbesondere ist hierbei eine jeweilige Ausgestaltung als kapazitiver Sensor oder als optischer Sensor umfasst. Die Ausgestaltung als berührungslose Abstandssensoren hat für den Benutzer den Vorteil, dass die Qualität der jeweiligen Abstandssignale nicht von der Stärke einer Berührung mit der Haut im äußeren Gehörgang abhängig ist, was andernfalls als unangenehm empfunden werden könnte. Zudem sind gerade im vorliegenden Fall, in welchem eine Berührung im äußeren Gehörgang erfolgt, aufgrund der komplexen Geometrie des Gehörgangs und der möglichen Feuchtigkeit der dortigen Haut weniger störungsanfällig.

Günstigerweise ist hierfür der erste Abstandssensor und/oder der zweite Abstandssensor jeweils als ein kapazitiver Sensor ausgebildet. Die Auswahl kapazitive Abstandssensoren, welche bereits bei einer sehr kompakten Bauform für die vorliegende Anwendung ausreichend aussagekräftige Abstandssignale erzeugen, als erster und/oder zweiter Abstandssensor ist angesichts des begrenzten Bauraums im Ohrstück besonders vorteilhaft.

Bevorzugt werden wird erste Abstandssensor und/oder der zweite Abstandssensor jeweils gebildet durch ein flächiges Elektrodenpaar, wobei die beiden Elektroden des Elektrodenpaars des jeweiligen Abstandssensors, bevorzugt in einem relativ zu ihren Abmessungen geringen Abstand zueinander, einander gegenüber liegend angeordnet sind. Bevorzugt ist dabei der Raum zwischen den beiden Elektroden eines Abstandssensors mit einem Dielektrikum gefüllt. Die genannte Ausgestaltung macht sich den Umstand zu nutzen, dass in einem kapazitiven Bauelement die elektrische Kapazität bei den üblichen Bauformen mit zunehmendem Abstand der beiden Elektroden des kapazitiven Bauelements abnimmt, und ein größerer räumlicher Überlapp für die elektrische Kapazität vorteilhaft ist. Da in einem kapazitiven Abstandssensor Veränderungen im Abstandssignal bei einem gleichbleibenden Referenz-Auslösereiz weitgehend linear von der elektrischen Kapazität abhängen, ist eine möglichst hohe elektrische Kapazität erwünscht. Durch die oben genannte Bauweise lässt sich ein kapazitiver Abstandssensor mit vergleichsweise hoher elektrischer Kapazität bei kompakter Bauform realisieren.

Die Erfindung nennt weiter ein Verfahren zum Steuern eines Hörgerätes, insbesondere Hörhilfegerätes, welches ein Ohrstück mit einem ersten Abstandssensor und einem zweiten Abstandssensor umfasst, wobei der erste Abstandssensor und der zweite Abstandssensor im Ohrstück bezüglich einer Einführrichtung des Hörgeräts in den äußeren Gehörgang hintereinander angeordnet sind, wobei der erste Abstandssensor ein erstes Abstandssignal generiert, wobei der zweite Abstandssensor ein zweites Abstandssignal generiert, wobei das Ohrstück für den Betrieb des Hörgeräts wenigstens teilweise in den äußeren Gehörgang eines Benutzers des Hörgeräts eingeführt wird, und wobei im Falle einer bei einem Einführen des Hörgeräts in den äußeren Gehörgang eintretenden Veränderung des ersten Abstandssignals und einer in einem vorgegebenen Zeitabstand darauf folgenden Veränderung des zweiten Abstandssignals das Hörgerät in einen aktiven Betriebszustand versetzt wird, und/oder im Falle einer bei einem Entfernen des Hörgeräts aus dem äußeren Gehörgang eintretenden Veränderung des zweiten Abstandssignals und einer in einem vorgegebenen Zeitabstand darauf folgenden Veränderung des ersten Abstandssignals das Hörgerät in einen inaktiven Betriebszustand versetzt werden. Die für das Hörgerät und seine Weiterbildungen genannten Vorteile können hierbei sinngemäß auf das Verfahren übertragen werden.

Vorteilhafterweise wird hierbei eine Veränderung des ersten Abstandssignals und eine in einem vorgegebenen Zeitabstand darauf folgende Veränderung des zweiten Abstandssignals registriert, und daraufhin das Hörgerät in einen aktiven Betriebszustand versetzt, und/oder eine Veränderung des zweiten Abstandssignals und eine in einem vorgegebenen Zeitabstand darauf folgende Veränderung des ersten Abstandssignals registriert, und daraufhin das Hörgerät in einen inaktiven Betriebszustand versetzt.

Als vorgegebener Zeitabstand ist hierbei insbesondere ein Zeitabstand aus einem vorgegebenen Intervall umfasst. Der vorgegebene Zeitabstand bzw. das Intervall ist hierbei so zu wählen, dass eine Einführbewegung des Ohrstücks in den äußeren Gehörgang des Benutzers und/oder ein Entfernen des Ohrstücks aus dem äußeren Gehörgang bei üblichermaßen anzunehmenden Bewegungsabläufen erkannt werden kann. Die entsprechenden Bewegungsgeschwindigkeiten sind dabei bevorzugt abzuschätzen oder exemplarisch zu messen. Bevorzugt ist dabei im aktiven Betriebszustand das Hörgerät zum Betrieb mit allen wesentlichen Funktionen eingerichtet, wobei im inaktiven Betriebszustand alle wesentlichen Funktionen des Hörgeräts, ggf. mit Ausnahme der Energieverwaltung und der Steuerung der Betriebszustände selbst, deaktiviert sind.

Das Ansteuern des aktiven bzw. inaktiven Betriebszustands anhand der zeitlichen Abfolge der Veränderungen im ersten Abstandssignal und im zweiten Abstandssignalmacht sich den Umstand zunutze, dass bei hierbei in Einführen des Ohrstücks in den äußeren Gehörgang bzw. ein Entfernen des Ohrstücks aus dem äußeren Gehörgang mit geringem Fehlerrisiko erkannt werden kann, woraus vergleichsweise sicher eine gewünschte Aufnahme bzw. Beendigung des Betriebs geschlossen werden kann, und entsprechend der Betriebszustand des Hörgeräts gesteuert werden.

Nachfolgend wird ein Ausführungsbeispiel der Erfindung anhand einer Zeichnung näher erläutert. Hierbei zeigen jeweils schematisch:
- Fig. 1: in einer Schnittdarstellung ein ITE-Hörgerät mit einem Ohrstück, welches zwei Abstandssensoren aufweist,
- Fig. 2: eine alternative Anordnung der zwei Abstandssensoren im Ohrstück des Hörgeräts nach Fig. 1,
- Fig. 3: in einer Schnittdarstellung ein Ohrstück mit zwei Abstandssensoren für ein RIC-Hörgerät,
- Fig. 4: anhand der gegen eine Zeitachse aufgetragenen Abstandssignale der zwei Abstandssensoren ein Verfahren zur Steuerung eines nach Fig. 1 bis Fig. 3 ausgestalteten Hörgeräts, und
- Fig. 5: in einer Schnittdarstellung einen Ausschnitt aus einem Ohrstück, an dem eine Abstandssensor-Elektronik angeordnet ist.

Einander entsprechende Teile und Größen sind in allen Figuren jeweils mit gleichen Bezugszeichen versehen.

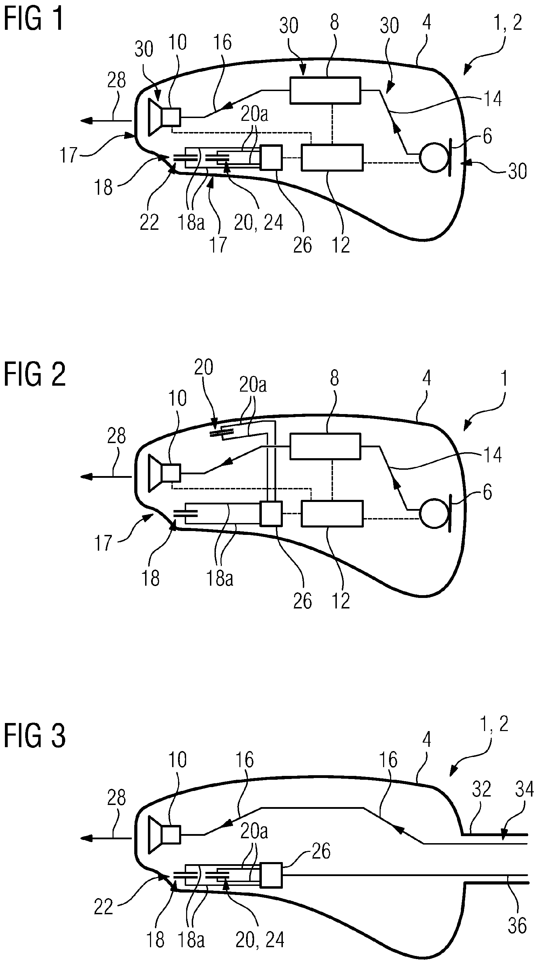

In Fig. 1 ist schematisch in einer Schnittdarstellung ein Hörgerät 1 gezeigt, welches im vorliegenden Fall als ein Hörhilfegerät 2 in "ITE"-Bauweise ausgestaltet ist. Das Hörgerät 1 umfasst ein Gehäuse 4, innerhalb dessen ein Mikrofon 6, eine Signalverarbeitungseinheit 8, ein Lautsprecher 10 und eine Leistungsquelle 12 angeordnet sind. Das Mikrofon 6 ist dazu eingerichtet, aus einem Schallsignal der Umgebung ein Eingangssignal 14 zu erzeugen, welches an die Signalverarbeitungseinheit 8 weitergeleitet, von dieser u.a. verstärkt und als Ausgangssignal 16 zur Wiedergabe an den Lautsprecher 10 ausgegeben wird. Zur Leistungsversorgung werden die Signalverarbeitungseinheit 8 und der Lautsprecher 10, und ggf. auch das Mikrofon 6 von der Leistungsquelle 12 gespeist, die hierfür vorzugsweise eine Batterie oder einen wiederaufladbaren Akkumulator aufweist.

Das Gehäuse 4 weist an einem Ohrstück 17 weiter einen ersten Abstandssensor 18 sowie einen zweiten Abstandssensor 20 auf. Der erste Abstandssensor 18 bzw. der zweite Abstandssensor 20 werden jeweils gebildet durch einen kapazitiven Sensor, welcher jeweils ein flächiges Elektrodenpaar 22, 24 aufweist. Die beiden Elektroden 22 des ersten Abstandssensors 18 und die beiden Elektroden 24 des zweiten Abstandssensors 20 sind jeweils mit einer Steuereinheit 26 verbunden. Im vorliegenden Fall kann beispielsweise eine dauerhafte Signalverbindung bestehen, d.h., es wird kontinuierlich die am jeweiligen Abstandssensor 18, 20 vorliegende Kapazität als jeweiliges Abstandssignal 18a, 20a an die Steuereinheit 26 übermittelt. Ebenso ist jedoch auch ein gepulster Betrieb der beiden Abstandssensoren 18, 20 möglich, so dass mit einer hinreichend hohen Pulswiederholfrequenz - vorzugsweise im Bereich von einigen Hundert bis einigen Tausend Hertz - die jeweils instantan vorliegende Kapazität übermittelt wird. Die kapazitiven Abstandssensoren 18, 20 sind dabei ausgelegt, dass bei einer Berührung des Gehäuses durch menschliche Haut in unmittelbarer Nähe des jeweiligen Abstandssensors 18, 20 eine merkliche Veränderung in dessen Abstandssignal 18a, 20a, welches zur Steuereinheit 26 übermittelt wird, nachweisbar ist.

Das Hörgerät 1 ist für den ordnungsgemäßen Betrieb mit dem Ohrstück 17 in einen nicht näher dargestellten äußeren Gehörgang eines Benutzers des Hörgeräts 1 einzuführen. Entsprechend kann anhand der Anordnung des Mikrofons 6 und des Lautsprechers 10 im Gehäuse 4 und anhand der Form des Gehäuses 4 eine Einführrichtung 28 definiert werden als die Bewegungsrichtung, welche das Hörgerät 1 unter den anatomisch gegebenen räumlichen Restriktionen beim Einführen in den äußeren Gehörgang vollführt. Der erste Abstandssensor 18 und der zweite Abstandssensor 20 sind im Gehäuse 4 bezüglich der Einführrichtung 28 hintereinander angeordnet.

Es wird nun angenommen, dass das Hörgerät 1 sich zunächst nicht in Betrieb befindet, und somit entsprechend vom Benutzer gelagert wird. Die den Signalweg 30 bildenden Komponenten, also das Mikrofon 6, die Signalverarbeitungseinheit 8 und der Lautsprecher 10, werden dabei von der Leistungsquelle 12 nicht mit Leistung versorgt, um Energie zu spare. Lediglich die Steuereinheit 26 für das Steuern der Betriebszustände wird im inaktiven Zustand durch die Leistungsquelle 12 gespeist, um einen Wechsel in den aktiven Betriebszustand, in welchem auch die Komponenten des Signalwegs 30 versorgt werden, zu ermöglichen.

Dieser Wechsel wird nun erreicht, indem bei einem Einführen des Hörgeräts in den äußeren Gehörgang des Benutzers zunächst das Gehäuse 4 im Bereich des ersten Abstandssensors 18 die Haut am äußeren Gehörgang berührt, wodurch eine Veränderung im ersten Abstandssignal 18a des ersten Abstandssensors 18 eintritt. Infolge der Tatsache, dass der zweite Abstandssensor 20 bezüglich der Einführrichtung 28 hinter dem ersten Abstandssensor 18 angeordnet ist, wird das Gehäuse 4 beim Einführen in den äußeren Gehörgang durch die Haut erst später berührt, wodurch sich die entsprechende, durch die Berührung hervorgerufene Veränderung im zweiten Abstandssignal 20a des zweiten Abstandssensors 20 auch erst später ereignet als die Veränderung im ersten Abstandssignal 18a des ersten Abstandssensors 18. Anhand dieser zeitlichen Abfolge der Veränderungen im ersten Abstandssignal 18a und im zweiten Abstandssignal 20a kann nun die Steuereinheit 26 auf ein Einführen des Hörgeräts 1 in den äußeren Gehörgang schließen, und entsprechend der Annahme, dass dies zur Inbetriebnahme des aktiven Betriebszustands erfolgt, das Hörgerät in den aktiven Betriebszustand versetzen, in welchem auch die Komponenten des Signalwegs 30 durch die Leistungsquelle mit Leistung versorgt werden.

Umgekehrt kann aus der zeitlichen Abfolge der Veränderungen im ersten Abstandssignal 18a und im zweiten Abstandssignal 20a ein Entfernen des Hörgeräts 1 aus dem äußeren Gehörgang erkannt werden. Dieses erfolgt aufgrund der anatomischen Begebenheiten in umgekehrter Einführrichtung, so dass das Gehäuse 4 zuerst im Bereich des zweiten Abstandssensors 20 nicht mehr von der Haut im Gehörgang berührt wird, was zu einer Veränderung im entsprechenden zweiten Abstandssignal 20a führt. Erst danach wird auch der Bereich des ersten Abstandssensors 18 vollständig aus dem Gehörgang entfernt wird, weswegen die Veränderung im entsprechenden ersten Abstandssignal 18a mit registrierbarer zeitlicher Verzögerung auf die Veränderung im zweiten Abstandssignal 20a eintritt. Die Steuereinheit 26 erkennt anhand dieser Abfolge der zeitlichen Veränderungen der beiden Abstandssignale 20a, 18a das Entfernen aus dem äußeren Gehörgang, und schließt auf ein gewünschtes Ende des bestimmungsgemäßen Betriebs des Hörgeräts. Entsprechend wird das Hörgerät 1 zum Energiesparen in den inaktiven Betriebszustand versetzt.

In Fig. 2 ist schematisch in einer Schnittdarstellung eine alternative Anordnung der beiden Abstandssensoren 18, 20 im Hörgerät nach Fig. 1 gezeigt. Der erste Abstandssensor 18 und der zweite Abstandssensor 20 liegen sich hierbei im Gehäuse 4 gegenüber, sind jedoch bezüglich der Einführrichtung 28 derart versetzt, dass auch in dieser Ausgestaltung bei einem Einführen in den äußeren Gehörgang bzw. einem Entfernen aus dem äußeren Gehörgang des Benutzers die hierdurch bedingten Veränderungen in den Abstandssignalen 18a, 20a der Abstandssensoren 18, 20 mit zeitlicher Versetzung eintreten, anhand derer die Steuereinheit 26 die Bewegungsrichtung des Hörgeräts 1 relativ zum Gehörgang und entsprechend den gewünschten Betriebszustand erkennen kann.

In Fig. 3 ist schematisch ein Ohrstück 17 eines nicht näher dargestellten Hörhilfegeräts dargestellt, wobei das Hörhilfegerät hier in "RIC"-Bauweise ("Receiver In the Canal") ausgestaltet ist. Entsprechend weist das Ohrstück 17, welches für den Betrieb des Hörhilfegeräts von dessen Benutzer in den äußeren Gehörgang einzuführen ist, einen Lautsprecher 10 auf, der über eine durch ein Verbindungsstück 32 führende Signalleitung 34 von der Signalverarbeitungseinheit des Hörhilfegeräts ein Ausgabesignal 16 zur Wiedergabe empfängt. Weiter weist das Ohrstück 17 zwei Abstandssensoren 18, 20 auf, welche jeweils durch ein flächiges Elektrodenpaar 22 bzw. 24 gebildet werden, und dazu eingerichtet sind, ein Abstandssignal 18a bzw. 20a an eine Steuereinheit 26 zu übermitteln.

Wird nun das Ohrstück 17 für den Beginn des bestimmungsgemäßen Betriebs in Einführrichtung 28 in den äußeren Gehörgang eingeführt, so wird zunächst eine Veränderung im Abstandssignal 18a, und anschließend eine Veränderung im Abstandssignal 20a von der Steuereinheit 26 registriert. Die Steuereinheit gibt über einen durch das Verbindungsstück 32 führenden Steuerkanal 36 ein entsprechendes Signal an das Hörhilfegerät, welches hierdurch in den aktiven Betriebszustand versetzt wird. Insbesondere umfasst hierbei der Steuerkanal 36 auch die Leistungsversorgung der Steuereinheit 26 und, über diese, der Abstandssensoren 18, 20. Die Auswahl des inaktiven Betriebszustands des Hörhilfegeräts durch die Steuereinheit 26 bei einem Entfernen des Ohrstücks 17 aus dem äußeren Gehörgang verläuft analog.

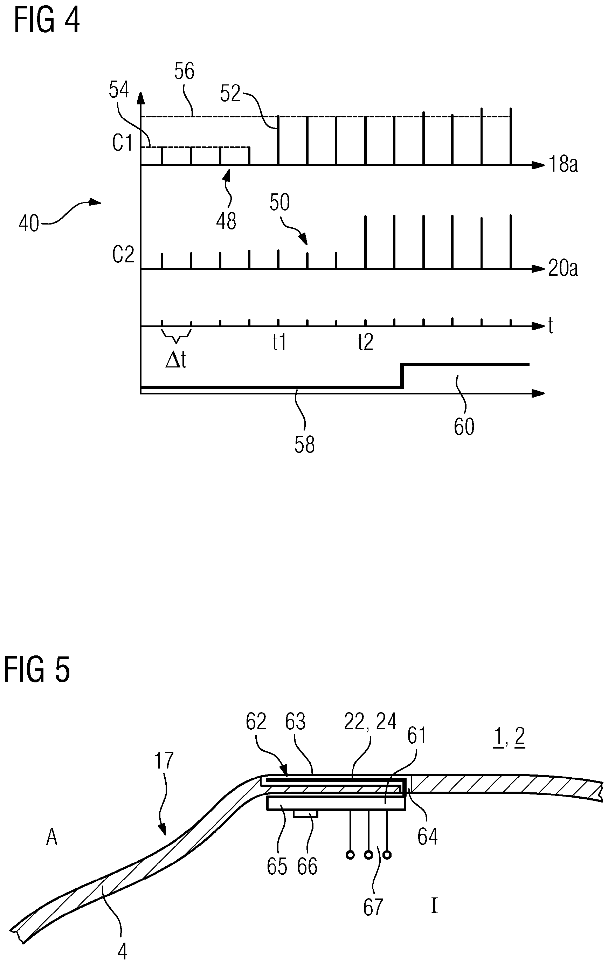

In Fig. 4 ist der Ablauf eines Verfahrens 40 gezeigt, durch welches ein nach Fig. 1 oder Fig. 2 oder Fig. 3 ausgestaltetes Hörgerät 1 zu steuern ist. Jeweils gegen einen Zeitstrahl t sind dabei das erste Abstandssignal 18a und das zweite Abstandssignal 20a als Wert der jeweiligen Kapazität C1 bzw. C2 am Abstandssensor 18 bzw. 20 aufgetragen. Die beiden Abstandssensoren 18, 20 übermitteln in festen Zeitabständen Δt, welche durch die inverse Pulswiederholfrequenz gegeben sind, einzelne Pulse 48, 50 des ersten Abstandssignals 18a bzw. des zweiten Abstandssignals 20a an die Steuereinheit 26. Diese Werte können hierbei einer gewissen Schwankungsbreite unterliegen. Im vorliegenden Fall wiederfährt zuerst das erste Abstandssignal zu einem Zeitpunkt t1 eine Veränderung, indem die Kapazität C1 des ersten Abstandssensors 18 ab dem entsprechenden Puls 52 einen merklich größeren Wert annimmt. Mit einigen Pulsen Verzögerung nimmt auch die Kapazität C2 des zweiten Abstandssensors 20 ab einem Zeitpunkt t2 > t1 größere Werte an als vor t2.

Aus dieser zeitlichen Abfolge der Erhöhung der Kapazitätswerte in den Abstandssignalen 18a, 20a kann geschlossen werden, dass das Gehäuse zuerst im Bereich des ersten Abstandssensors 18 mit der Haut des Benutzers des Hörgeräts in Berührung gekommen ist - zum Zeitpunkt t1 - und anschließend das Gehäuse auch mit dem Bereich des zweiten Abstandssensors 20 in Berührung mit der Haut gekommen ist. Anhand der Tatsache, dass dabei auch nach t2 das erste Abstandssignal 18a nicht wieder auf seinen mittleren Ausgangswert 54 absinkt, sondern in etwa beim erhöhten Wert 56 bleibt, den es ab dem Puls 52 bei t1 einnimmt, kann geschlossen werden, dass ein Einführen des Hörgeräts in den äußeren Gehörgang des Benutzers vorliegen muss. Entsprechend wird das Hörgerät 1 von einem inaktiven Betriebszustand 58 in einen aktiven Betriebszustand 60 versetzt. Insbesondere ist vorgesehen, dass zwischen der Veränderung im ersten Abstandssignal 18a und der Veränderung im zweiten Abstandssignal 20a eine bestimmte Zeitspanne, beispielsweise aus einem Intervall, welches durch eine Mindestanzahl und eine Höchstanzahl an Pulsen definiert ist, zu vergehen hat, um ein Ansteuern eines anderen Betriebszustands auszulösen.

Das Ansteuern des inaktiven Betriebszustands 58 beim Entfernen des Hörgeräts aus dem äußeren Gehörgang verläuft analog. Ggf. kann die Pulswiederholfrequenz 1/Δt mit zunehmender Verweildauer im selben Betriebszustand (hier: im aktiven Betriebszustand 60) nach und nach vergrößert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

In Figur 5 ist in einer Schnittdarstellung ein Ausschnitt aus einem Ohrstück 17 eines Hörgeräts 1 bzw. Hörhilfegeräts 2 dargestellt, an dem eine Abstandssensor-Elektronik 61 mit einem ersten und zweiten Elektrodenpaar 22, 24 angeordnet ist. Jedes der beiden Elektrodenpaare 22, 24 bildet somit einen kapazitiven Abstandssensor 18 bzw. 20. In der gezeigten Schnittdarstellung ist dabei nur eines der beiden Elektrodenpaare 22, 24 erkennbar. Das Ohrstück 17 ist beispielsweise Teil eines Hörhilfegeräts 2 in RIC-Bauweise oder in ITE-Bauweise.

Die Elektrodenpaare 22, 24 der Abstandssensor-Elektronik 61 sind in einer Vertiefung 62 auf der Außenseite A des Gehäuses 4 des Ohrstücks 17 angeordnet. Zum Schutz vor äußeren Einflüssen sind die Elektrodenpaare 22, 24 weiter mit einer Versiegelung 63 versehen. Die Versiegelung 63 ist in einer möglichen Ausführungsvariante durch einen auf der Außenseite A aufgetragenen Lack realisiert. Jedes der Elektrodenpaare 22, 24 ist beispielsweise durch zwei ineinander greifende kammförmige Elektroden ausgebildet.

Über einen Spalt 64 im Gehäuse 4 sind die Elektrodenpaare 22, 24 mit einer auf der Innenseite I des Gehäuses 4 des Ohrstücks 17 angeordneten Leiterplatte 65 der Abstandssensor-Elektronik 61 kontaktiert. Zur Ansteuerung, Erfassung, Auswertung und Bereitstellung von Messdaten ist auf der Leiterplatte 65 weiter ein integrierter Schaltkreis 66, beispielsweise in Form eines Mikrochips, oder ein Mikrocontroller abgeordnet. Über Zuleitungen 67 erfolgt der Datenaustausch zwischen der Abstandssensor-Elektronik 61 und einer hier nicht dargestellten Steuereinheit (z.B. 26) des Hörgeräts 1 bzw. Hörhilfegeräts 2. Eine Auswahl entsprechender aktiver und inaktiver Betriebsmodi des Hörgeräts 1 oder Hörhilfegeräts 2 erfolgt durch die Steuereinheit abhängig von den Signalen der Abstandssensor-Elektronik 61.

### Bezugszeichenliste

- 1: Hörgerät
- 2: Hörhilfegerät
- 4: Gehäuse
- 6: Mikrofon
- 8: Signalverarbeitungseinheit
- 10: Lautsprecher
- 12: Leistungsquelle
- 14: Eingangssignal
- 16: Ausgangssignal
- 17: Ohrstück
- 18: erster Abstandssensor
- 18a: erstes Abstandssignal
- 20: zweiter Abstandssensor
- 20a: zweites Abstandssignal
- 22: (erstes) Elektrodenpaar
- 24: (zweites) Elektrodenpaar
- 26: Steuereinheit
- 28: Einführrichtung
- 30: Signalweg
- 32: Verbindungsstück
- 34: Signalleitung
- 36: Steuerkanal
- 40: Verfahren
- 48: Puls des ersten Abstandssignals
- 50: Puls des zweiten Abstandssignals
- 52: Puls des ersten Abstandssignals
- 54: (mittlerer) Ausgangswert des ersten Abstandssignals
- 56: erhöhter Wert des ersten Abstandssignals
- 58: inaktiver Betriebszustand
- 60: aktiver Betriebszustand
- 61: Abstandssensor-Elektronik
- 62: Vertiefung
- 63: Versiegelung
- 64: Spalt
- 65: Leiterplatte
- 66: IC, µC
- 67: Zuleitungen

- A: Außenseite
- I: Innenraum
- C1: erste Kapazität
- C2: zweite Kapazität
- t: Zeitstrahl
- t1: Zeitpunkt
- t2: Zeitpunkt
- Δt: Zeitabstand
- 1/Δt: Pulswiederholfrequenz

## Patentansprüche

1. Hörgerät (1), insbesondere Hörhilfegerät (2), umfassend ein Ohrstück (17) mit einem ersten Abstandssensor (18) und einem zweiten Abstandssensor (20) sowie eine Steuereinheit (26),
wobei der erste Abstandssensor (18) dazu eingerichtet ist, ein erstes Abstandssignal (18a) an die Steuereinheit (26) zu übermitteln,
wobei der zweite Abstandssensor (20) dazu eingerichtet ist, ein zweites Abstandssignal (20a) an die Steuereinheit (26) zu übermitteln,
wobei das Ohrstück (17) für den Betrieb des Hörgeräts (1) wenigstens teilweise in den äußeren Gehörgang eines Benutzers des Hörgeräts (1) einführbar ist,
wobei der erste Abstandssensor (18) und der zweite Abstandssensor (20) im Ohrstück (17) bezüglich einer Einführrichtung (28) des Hörgeräts (1) in den äußeren Gehörgang hintereinander angeordnet sind, und
wobei die Steuereinheit (26) dazu eingerichtet ist,
- im Falle einer bei einem Einführen des Hörgeräts (1) in den äußeren Gehörgang eintretenden Veränderung des ersten Abstandssignals (18a) und einer in einem vorgegebenen Zeitabstand darauf folgenden Veränderung des zweiten Abstandssignals (20a) das Hörgerät (1) in einen aktiven Betriebszustand (60) zu versetzen, und/oder
- im Falle einer bei einem Entfernen des Hörgeräts (1) aus dem äußeren Gehörgang eintretenden Veränderung des zweiten Abstandssignals (20a) und einer in einem vorgegebenen Zeitabstand darauf folgenden Veränderung des ersten Abstandssignals (18a) das Hörgerät (1) in einen inaktiven Betriebszustand (58) zu versetzen.

2. Hörgerät (1) nach Anspruch 1,
wobei die Steuereinheit (26) dazu eingerichtet ist, den Betriebszustand (58, 60) des Hörgerätes (1) in Abhängigkeit einer zeitlichen Abfolge von Veränderungen des ersten Abstandssignals (18a) und des zweiten Abstandssignals (20a) zu steuern.

3. Hörgerät (1) nach einem der vorhergehenden Ansprüche,
wobei das erste Abstandssignal (18a) vom ersten Abstandssensor (18) in einem gepulsten Betrieb mit einer definierten ersten Pulswiederholfrequenz (1/Δt) an die Steuereinheit (26) übermittelt wird, und/oder wobei das zweite Abstandssignal (20a) vom zweiten Abstandssensor (20) in einem gepulsten Betrieb mit einer definierten zweiten Pulswiederholfrequenz (1/Δt) an die Steuereinheit (26) übermittelt wird.

4. Hörgerät (1) nach Anspruch 3,
wobei die definierte erste Pulswiederholfrequenz (1/Δt) und/oder die definierte zweite Pulswiederholfrequenz (1/Δt) nach einem vorgegebenen Zeitintervall in einem aktiven Betriebszustand (60) und/oder in einem inaktiven Betriebszustand (58) des Hörgeräts (1) verringert wird.

5. Hörgerät (1) nach einem der vorhergehenden Ansprüche,
wobei der erste Abstandssensor (18) und/oder der zweite Abstandssensor (20) jeweils als ein berührungsloser Abstandssensor ausgebildet ist.

6. Hörgerät (1) nach Anspruch 5,
wobei der erste Abstandssensor (18) und/oder der zweite Abstandssensor (20) jeweils als ein kapazitiver Sensor ausgebildet ist.

7. Hörgerät (1) nach Anspruch 6,
wobei der erste Abstandssensor (18) und/oder der zweite Abstandssensor (20) jeweils gebildet wird durch ein flächiges Elektrodenpaar (22, 24), wobei die beiden Elektroden des Elektrodenpaars (22, 24) des jeweiligen Abstandssensors (18, 20) einander gegenüber liegend angeordnet sind.

8. Verfahren (40) zum Steuern eines Hörgerätes (1), insbesondere Hörhilfegerätes (2), welches ein Ohrstück (17) mit einem ersten Abstandssensor (18) und einem zweiten Abstandssensor (20) umfasst, wobei der erste Abstandssensor (18) und der zweite Abstandssensor (20) im Ohrstück (17) bezüglich einer Einführrichtung (28) des Hörgeräts (1) in den äußeren Gehörgang hintereinander angeordnet sind,
wobei der erste Abstandssensor (18) ein erstes Abstandssignal (18a) generiert,
wobei der zweite Abstandssensor (20) ein zweites Abstandssignal (20a) generiert,
wobei das Ohrstück (17) für den Betrieb des Hörgeräts (1) wenigstens teilweise in den äußeren Gehörgang eines Benutzers des Hörgeräts (1) eingeführt wird, und
wobei,
- im Falle einer bei einem Einführen des Hörgeräts (1) in den äußeren Gehörgang eintretenden Veränderung des ersten Abstandssignals (18a) und einer in einem vorgegebenen Zeitabstand darauf folgenden Veränderung des zweiten Abstandssignals (20a) das Hörgerät (1) in einen aktiven Betriebszustand (60) versetzt wird, und/oder
- im Falle einer bei einem Entfernen des Hörgeräts (1) aus dem äußeren Gehörgang eintretenden Veränderung des zweiten Abstandssignals (20a) und einer in einem vorgegebenen Zeitabstand darauf folgenden Veränderung des ersten Abstandssignals (18a) das Hörgerät (1) in einen inaktiven Betriebszustand (58) versetzt wird.

9. Verfahren (40) nach Anspruch 8,
wobei
- eine Veränderung des ersten Abstandssignals (18a) und eine in einem vorgegebenen Zeitabstand darauf folgende Veränderung des zweiten Abstandssignals (20a) registriert wird, und daraufhin das Hörgerät (1) in einen aktiven Betriebszustand (60) versetzt wird, und/oder
- eine Veränderung des zweiten Abstandssignals (20a) und eine in einem vorgegebenen Zeitabstand darauf folgende Veränderung des ersten Abstandssignals (18a) registriert wird, und daraufhin das Hörgerät (1) in einen inaktiven Betriebszustand versetzt (58) wird.

## Claims

1. Hearing device (1), in particular hearing aid (2), comprising an earpiece (17) with a first distance sensor (18) and a second distance sensor (20) and a control unit (26),
wherein the first distance sensor (18) is configured to transmit a first distance signal (18a) to the control unit (26),
wherein the second distance sensor (20) is configured to transmit a second distance signal (20a) to the control unit (26),
wherein for the operation of the hearing device (1) the earpiece (17) can be inserted at least partially into the external ear canal of a user of the hearing device (1),
wherein the first distance sensor (18) and the second distance sensor (20) are arranged one behind the other in the earpiece (17) with respect to an insertion direction (28) of the hearing device (1) into the external ear canal, and
wherein the control unit (26) is configured
- to set the hearing device (1) to an active operating state (60) in the event of a change in the first distance signal (18a) occurring when the hearing device (1) is inserted into the external ear canal and in the event of a subsequent change in the second distance signal (20a) at a predetermined time interval, and/or
- to set the hearing device (1) to an inactive operating state (58) in the event of a change in the second distance signal (20a) occurring when the hearing device (1) is removed from the external ear canal and in the event of a subsequent change in the first distance signal (18a) at a predetermined time interval.

2. Hearing device (1) according to Claim 1,
wherein the control unit (26) is configured to control the operating state (58, 60) of the hearing device (1) depending on a chronological sequence of changes in the first distance signal (18a) and the second distance signal (20a).

3. Hearing device (1) according to one of the preceding claims,
wherein the first distance signal (18a) is transmitted from the first distance sensor (18) to the control unit (26) in a pulsed operation with a defined first pulse repetition frequency (1/Δt), and/or wherein the second distance signal (20a) is transmitted from the second distance sensor (20) to the control unit (26) in a pulsed operation with a defined second pulse repetition frequency (1/Δt).

4. Hearing device (1) according to Claim 3,
wherein, after a predetermined time interval in an active operating state (60) and/or in an inactive operating state (58) of the hearing device (1), the defined first pulse repetition frequency (1/Δt) and/or the defined second pulse repetition frequency (1/Δt) is reduced.

5. Hearing device (1) according to one of the preceding claims,
wherein the first distance sensor (18) and/or the second distance sensor (20) are each designed as a contactless distance sensor.

6. Hearing device (1) according to Claim 5,
wherein the first distance sensor (18) and/or the second distance sensor (20) are each designed as a capacitive sensor.

7. Hearing device (1) according to Claim 6,
wherein the first distance sensor (18) and/or the second distance sensor (20) are each formed by a planar pair of electrodes (22, 24), wherein the two electrodes of the pair of electrodes (22, 24) of each respective distance sensor (18, 20) are arranged opposite each other.

8. Method (40) for controlling a hearing device (1), in particular a hearing aid (2), which comprises an earpiece (17) with a first distance sensor (18) and a second distance sensor (20), wherein the first distance sensor (18) and the second distance sensor (20) are arranged one behind the other in the earpiece (17) with respect to an insertion direction (28) of the hearing device (1) into the external ear canal,
the first distance sensor (18) generating a first distance signal (18a),
the second distance sensor (20) generating a second distance signal (20a),
wherein the earpiece (17) for the operation of the hearing device (1) is at least partially inserted into the external ear canal of a user of the hearing device (1), and
wherein
- the hearing device (1) is set to an active operating state (60) in the event of a change in the first distance signal (18a) occurring when the hearing device (1) is inserted into the external ear canal and in the event of a subsequent change in the second distance signal (20a) at a predetermined time interval, and/or
- the hearing device (1) is set to an inactive operating state (58) in the event of a change in the second distance signal (20a) occurring when the hearing device (1) is removed from the external ear canal and in the event of a subsequent change in the first distance signal (18a) at a predetermined time interval.

9. Method (40) according to Claim 8,
wherein
- a change in the first distance signal (18a) and a subsequent change in the second distance signal (20a) a predetermined time interval is registered, and then the hearing device (1) is set to an active operating state (60), and/or
- a change in the second distance signal (20a) and a subsequent change in the first distance signal (18a) at a predetermined time interval is registered, and then the hearing device (1) is set to an inactive operating state (58).

## Revendications

1. Appareil auditif (1), en particulier aide auditive (2), comprenant un écouteur (17) avec un premier capteur de distance (18) et un deuxième capteur de distance (20) et une unité de commande (26), dans lequel le premier capteur de distance (18) est configuré pour transmettre un premier signal de distance (18a) à l'unité de commande (26),
dans lequel le deuxième capteur de distance (20) est configuré pour transmettre un deuxième signal de distance (20a) à l'unité de commande (26),
dans lequel, pour le fonctionnement de l'appareil auditif (1), l'écouteur (17) peut être inséré au moins partiellement dans le canal auditif externe d'un utilisateur de l'appareil auditif (1),
dans lequel le premier capteur de distance (18) et le deuxième capteur de distance (20) sont disposés l'un derrière l'autre dans l'écouteur (17) par rapport à une direction d'insertion (28) de l'appareil auditif (1) dans le canal auditif externe, et
dans lequel l'unité de commande (26) est configurée pour
- mettre l'appareil auditif (1) dans un état de fonctionnement actif (60) en cas de changement du premier signal de distance (18a) survenant lorsque l'appareil auditif (1) est inséré dans le canal auditif externe et en cas d'un changement ultérieur du deuxième signal de distance (20a) selon un intervalle temporel prédéterminé, et/ou
- mettre l'appareil auditif (1) dans un état de fonctionnement inactif (58) en cas de changement du second signal de distance (20a) survenant lorsque l'appareil auditif (1) est retiré du canal auditif externe et en cas de un changement ultérieur du premier signal de distance (18a) selon un intervalle temporel prédéterminé.

2. Appareil auditif (1) selon la revendication 1,
dans lequel l'unité de commande (26) est configurée pour contrôler l'état de fonctionnement (58, 60) de l'appareil auditif (1) en function d'une séquence chronologique de changements dans le premier signal de distance (18a) et le second signal de distance (20a).

3. Appareil auditif (1) selon l'une des revendications précédentes,
dans lequel le premier signal de distance (18a) est transmis du premier capteur de distance (18) à l'unité de commande (26) dans une opération pulsée avec une première fréquence de répétition d'impulsions définie (1/Δt), et/ou le deuxième signal de distance (20a) est transmis du deuxième capteur de distance (20) à l'unité de commande (26) dans une opération pulsée avec une seconde fréquence de répétition d'impulsions définie (1/Δt).

4. Appareil auditif (1) selon la revendication 3,
dans lequel, après un intervalle de temps prédéterminé dans un état de fonctionnement actif (60) et/ou dans un état de fonctionnement inactif (58) de l'appareil auditif (1), la première fréquence de répétition d'impulsions définie (1/Δt) et/ou la deuxième fréquence de répétition d'impulsions définie (1/Δt) est réduite.

5. Appareil auditif (1) selon l'une des revendications précédentes,
dans lequel le premier capteur de distance (18) et/ou le deuxième capteur de distance (20) est chacun conçu comme un capteur de distance sans contact.

6. Appareil auditif (1) selon la revendication 5,
dans lequel le premier capteur de distance (18) et/ou le deuxième capteur de distance (20) est chacun conçu comme un capteur capacitif.

7. Appareil auditif (1) selon la revendication 6,
dans lequel le premier capteur de distance (18) et/ou le deuxième capteur de distance (20) est chacun formé par une paire d'électrodes plane (22, 24), les deux électrodes de la paire d'électrodes (22, 24) du capteur de distance respectif (18, 20) étant disposés face à face.

8. Procédé (40) pour contrôler un appareil auditif (1), en particulier une aide auditive (2), comprenant un écouteur (17) avec un premier capteur de distance (18) et un deuxième capteur de distance (20), le premier capteur de distance (18) et le deuxième capteur de distance (20) étant disposés l'un derrière l'autre dans l'écouteur (17) par rapport à une insertion de direction (28) de l'appareil auditif (1) dans le canal auditif externe,
le premier capteur de distance (18) générant un premier signal de distance (18a),
le deuxième capteur de distance (20) générant un second signal de distance (20a),
dans lequel, pour le fonctionnement de l'appareil auditif (1), l'écouteur (17) est au moins partiellement inséré dans le canal auditif externe d'un utilisateur de l'appareil auditif (1), et
dans lequel
- l'appareil auditif (1) est mis dans un état de fonctionnement actif (60) en cas de changement du premier signal de distance (18a) survenant lorsque l'appareil auditif (1) est inséré dans le canal auditif externe et en cas d'un changement ultérieur du deuxième signal de distance (20a) selon un intervalle temporel prédéterminé, et/ou
- l'appareil auditif (1) est mis dans un état de fonctionnement inactif (58) en cas de changement du deuxième signal de distance (20a) survenant lorsque l'appareil auditif (1) est retiré du canal auditif externe et en cas d'un changement ultérieur du premier signal de distance (18a) selon un intervalle temporel prédéterminé.

9. Procédé (40) selon la revendication 8,
dans lequel
- un changement du premier signal de distance (18a) et un changement ultérieur du deuxième signal de distance (20a) selon un intervalle temporel prédéterminé est enregistré, puis l'appareil auditif (1) est mis dans un état de fonctionnement actif (60), et/ou
- un changement du deuxième signal de distance (20a) et un changement ultérieur du premier signal de distance (18a) selon un intervalle temporel prédéterminé est enregistré, puis l'appareil auditif (1) est mis dans un état de fonctionnement inactif (58).
